# EUROPEAN PATENT SPECIFICATION

(11) **EP 2 574 418 B1**
(45) Date of publication and mention of the grant of the patent: **11.03.2015**
(21) Application number: 12006381.3
(22) Date of filing: 11.09.2012
(51) Int. Cl.: B23K 26/00, B23K 26/06, H01L 21/265, H01L 21/268, B23K 26/073

(54) **Laser annealing device and laser annealing method using a pulsed laser diode**
Laserglühvorrichtung und Laserglühverfahren unter Verwendung einer gepulsten Laserdiode
Dispositif de recuit au laser et procédé de recuit au laser utilisant une diode laser pulsée

(30) Priority: 27.09.2011 JP 2011210590
(43) Date of publication of application: 03.04.2013
(73) Proprietor: SUMITOMO HEAVY INDUSTRIES, LTD., Tokyo 141-6025 (JP)
(72) Inventor: Wakabayashi, Naoki, Yokosuka-shi Kanagawa 237-8555 (JP); Yorozu, Masafumi, Yokosuka-shi Kanagawa 237-8555 (JP)
(74) Representative: Wagner, Karl H.

(56) References cited:
- DE-A1- 10 052 899
- JP-A- 2011 119 297
- JP-A- 2011 134 736
- US-A- 5 385 092
- US-B1- 7 135 392

## Description

The present invention relates to a laser annealing device and a laser annealing method according to the preamble of claims 1 and 7 (see, for example, US 7, 135, 392, 131).

### DESCRIPTION OF RELATED ART

In heat treatment of a semiconductor wafer, particularly a silicon wafer, in general, heating using an electric furnace, rapid thermal annealing (RTA), and the like are applied. A heating time when RTA is applied is of millisecond order. In recent years, laser spike annealing in which the heating time is shorter than 1 µs is also applied.

In the laser spike annealing in which the heating time is shorter than 1 µs, since the heating time is short, a temperature gradient related to a thickness direction of a semiconductor wafer becomes steep. Thereby, it is difficult to heat a deep region of the semiconductor wafer to a desired temperature without excessively increasing the temperature of the surface of the semiconductor wafer. On the other hand, in RTA, since the heating time is long, the temperature of the entire semiconductor wafer is increased. According to the increase of the temperature of the semiconductor wafer, bending, slip (dislocation), or the like of the semiconductor wafer may occur.

In general, a pulse width of a high output pulse laser that can be applied to the semiconductor annealing is shorter than 1 µs or equal to or more than several hundreds of µs.

JP 2011-134736 A discloses a pulse fiber laser device which is a fiber laser including a laser light source for excitation for emitting excitation light, a fiber containing a laser active substance and allowing excitation light to be incident, and a pair of fiber gratings optically connected to each other with the fiber interposed. In the device, output light is emitted by interrupting an input current for driving the laser light source simultaneously with the emission of an optical pulse 16a from the fiber laser.

US 5,385,092 A discloses an apparatus and methods for imaging lithographic plates using laser devices that emit in the near-infrared region, and plates suitable for imaging with the apparatus and methods. Laser output either ablates one or more plate layers or physically transforms a surface layer, in either case resulting in an imagewise pattern of features on the plate. The image features exhibit an affinity for ink or an ink-abhesive fluid that differs from that of unexposed areas.

US 7,135,392 B1 discloses a method for forming P-N junctions in a semiconductor wafer, including ion implanting dopant impurities into the wafer and annealing the wafer using a thermal flux laser annealing apparatus that includes an array of semiconductor laser emitters arranged in plural parallel rows extending along a slow axis, plural respective cylindrical lenses overlying respective ones of the rows of laser emitters for collimating light from the respective rows along a fast axis generally perpendicular to the slow axis, a homogenizing light pipe having an input face at a first end for receiving light from the plural cylindrical lenses and an output face at an opposite end, the light pipe comprising a pair of reflective walls extending between the input and output faces and separated from one another along the direction of the slow axis, and scanning apparatus for scanning light emitted from the homogenizing light pipe across the wafer in a scanning direction parallel to the fast axis.

In addition, with regard to the available prior art, attention is further drawn to JP 2006-351659 A, JP 2011-60868 A, and JP 2011-119297 A.

### SUMMARY OF THE INVENTION

A general pulse waveform rises sharply from a starting time point of oscillation, shows a peak, and thereafter, decreases gently. At the time when power shows a peak, the surface of an annealing object is sharply heated and reaches a high temperature. Since time showing the peak is an instant, it is difficult to sufficiently heat a deep region of the annealing object.

According to one aspect of the present invention, there is provided a laser annealing device according to claim 1, that includes a laser diode that emits a laser pulse when a pulse current is input, an optical system that guides the laser beam emitted from the laser diode up to an annealing object, and a driver that supplies a pulse current that has a time waveform of a top flat and a pulse width of 1 µs to 100 µs to the laser diode.

According to another aspect of the present invention, there is provided a laser annealing method according to claim 7, that includes a step of ion-implanting a dopant on a second surface opposite to a first surface of a silicon wafer in which an element structure including an impurity diffusion region is formed on the first surface, and a step of, after implanting the dopant, emitting a pulse laser beam that has a wavelength of 690 nm to 950 nm, a pulse width of 10 µs to 100 µs, and a time waveform of a top flat on the second surface of the silicon wafer under conditions in which a power density on the surface of the silicon wafer is 250 kW/cm² to 750 kW/cm² and of activating the dopant.

By making the time waveform of the pulse current be the top flat, sufficient annealing can be performed even at a low peak power density. Heating time is dependent on the pulse width of the pulse current. However, the heating time is little dependent of a shape of a beam cross-section of the laser beam. Thereby, the heating time can be controlled with high accuracy.

### BRIEF DESCRIPTION OF THE DRAWINGS

Fig. 1 is a schematic view of a laser annealing device according to an embodiment.
Fig. 2 is a cross-sectional view of an insulated gate bipolar transistor (IGBT).
Fig. 3A is a view showing an example of a time waveform of a pulse laser beam that is used in a laser annealing method according to an embodiment, and Fig. 3B is a plan view of a beam cross-section on an annealing object.
Fig. 4 is a graph showing measurement results of a waveform of a pulse current that is supplied to a laser diode of a laser annealing device according to the embodiment and a waveform of a laser pulse that is emitted.
Fig. 5A is a graph showing a waveform of a top flat type laser pulse that is used in a simulation and a waveform of a general laser pulse, and Fig. 5B is a graph showing a temperature change at positions of depths of 0 µm, 3 µm, and 5 µm in a silicon wafer to which the top flat type laser pulse and the general laser pulse are incident.
Fig. 6 is a graph showing measurement results of electron concentration, positive hole concentration , phosphorous concentration, and boron concentration of a sample that is subjected to activation annealing of dopants using the laser annealing method according to the embodiment.
Fig. 7A is a graph showing simulation results of a temperature change when the laser beam having a top flat shape in space profile in the beam cross-section is incident upon the silicon wafer for each position in the width direction in the beam cross-section, and Fig. 7B is a graph showing simulation results of the temperature change when the laser beam having Gaussian distribution in space profile in the beam cross-section is incident upon the silicon wafer for each position in the width direction in the beam cross-section.

### DETAILED DESCRIPTION OF THE INVENTION

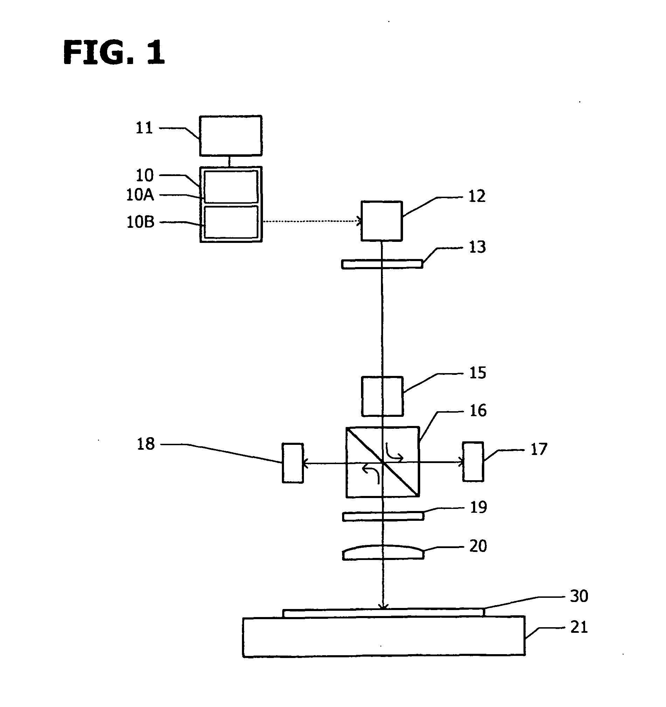

Fig. 1 is a schematic view of a laser annealing device according to an embodiment. A laser light source 12 is driven by a driver 10. As the laser light source 12, according to the present invention, a laser diode in particular having an oscillation wavelength of 690 nm to 950 nm is used. In the present embodiment, the laser diode having an oscillation wavelength of 800 nm is used.

The laser light source 12 includes a plurality of light emitting points which are horizontally oblong. The plurality of light emitting points are disposed in a line in the longitudinal direction thereof. For example, a ratio of the dimension between a long axis direction and a short axis direction of each of the light emitting points is 100:1. The dimension in the long axis direction of the light emitting point is substantially the same as an interval between two light emitting points adjacent to each other. In other words, the light emitting points and non-light emitting regions are alternatively arranged at regular intervals.

In general, a spread angle of the laser beam related to the long axis direction is larger than the spread angle of the laser beam related to the short axis direction. Thereby, it is difficult to narrow the beam cross-section related to the long axis direction. When a laser beam having a small spread angle such as a YAG laser or the like is used, power density can be increased by narrowing the beam cross-section. Incidentally, when the laser diode is used, since it is difficult to narrow the beam cross-section related to the long axis direction, increasing of the power density by narrowing the beam cross-section is difficult.

In an embodiment described below, compared to a laser annealing using a YAG laser or the like, sufficient annealing can be performed without increasing the power density.

The driver 10 includes a capacitor 10A and a pulse waveform shaping circuit 10B. For example, the pulse waveform shaping circuit 10B performs the shaping of the current waveform so that a discharge current from the capacitor 10A is a pulse current of a top flat. The pulse current of the top flat is supplied to the laser light source 12. For example, the pulse waveform shaping circuit 10B may be configured using a power semiconductor element such as a power MOSFET or an IGBT (Insulated Gate Bipolar Transistor) and a control circuit. The pulse current is supplied from the driver 10, and thereby, the laser light source 12 starts laser oscillating and emits a laser pulse.

The laser beam emitted from the laser light source 12 is incident to a half-wave plate 13. The half-wave plate 13 changes a polarization direction of the laser beam by changing a direction of a slow phase axis of the plate. The laser beam which transmits the half-wave plate 13 transmits a homogenizer 15, and then the laser beam is incident to a beam splitter 16. The beam splitter 16 reflects a portion of components of the incident laser beam toward a beam damper 17 and makes the remaining components go straight. A ratio of the components that go straight through the beam splitter 16 can be controlled by changing the direction of the slow phase axis of the half-wave plate 13 to change the polarization direction.

The laser beam that goes straight through the beam splitter 16 transmits a quarter wave plate 19 and a condensing lens 20 and is incident to a silicon wafer 30 which is an annealing object. The silicon wafer 30 is held to a movable stage 21. The beam cross-section on the surface of the silicon wafer 30 becomes a long shape by the homogenizer 15 and the condensing lens 20, and light intensity related to a long axis of the cross-section and a direction (width direction) perpendicular to the long axis is homogenized (the space profile becomes a top flat). For example, as the homogenizer 15, a kaleidoscope, an optical fiber, an array lens, a fly-eye lens, or the like may be used. The movable stage 21 moves the silicon wafer 30 in the width direction of the beam cross-section.

The light that is reflected on the surface of the silicon wafer 30 is transmitted to the condensing lens 20 and the quarter wave plate 19 and is incident to the beam splitter 16. The light passes through the quarter wave plate 19 twice, and thereby, the polarization direction is changed by 90°. Therefore, the reflected light is reflected by the beam splitter 16 and is incident to the beam damper 18.

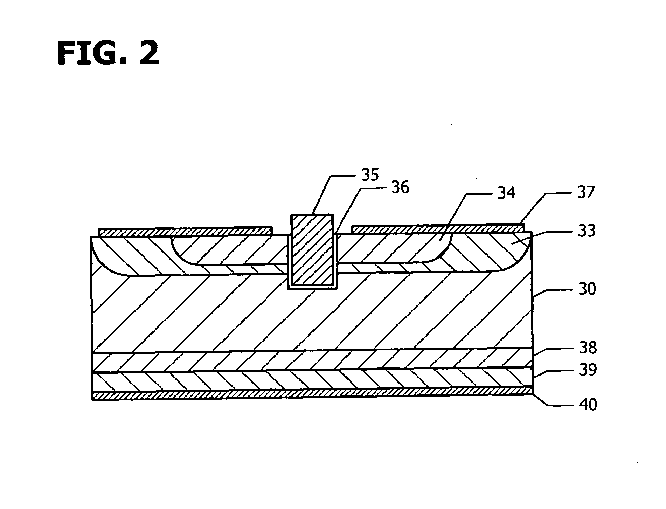

Fig. 2 shows a cross-section view of an insulated gate bipolar transistor (IGBT) as an example of a semiconductor device that is manufactured using a method according to an embodiment. An emitter and gate are formed on one surface of an n-type silicon substrate 30, a collector is formed on the other surface, and thereby, the IGBT is manufactured. The structure on the surface on which the emitter and gate are formed is manufactured according to a step similar to the manufacturing step of a general MOSFET. For example, as shown in Fig. 2, a p-type base region 33, an n-type emitter region 34, a gate electrode 35, a gate insulating film 36, and an emitter electrode 37 are disposed on the surface of the silicon substrate 30. According to the voltage between the gate and the emitter, an on-off control of the current can be performed.

A p-type collector layer 39 is formed on an opposite side surface of the silicon substrate 30. If necessary, an n-type buffer layer 38 may be formed between the collector layer 39 and the silicon substrate 30. For example, boron and phosphorous which are dopants are implanted using ion-implanting, activation annealing is performed, and thereby, the collector layer 39 and the buffer layer 38 are formed respectively. The laser annealing device shown in Fig. 1 is applied to the activation annealing. A collector electrode 40 is formed on the surface of the collector layer 39 after the activation annealing.

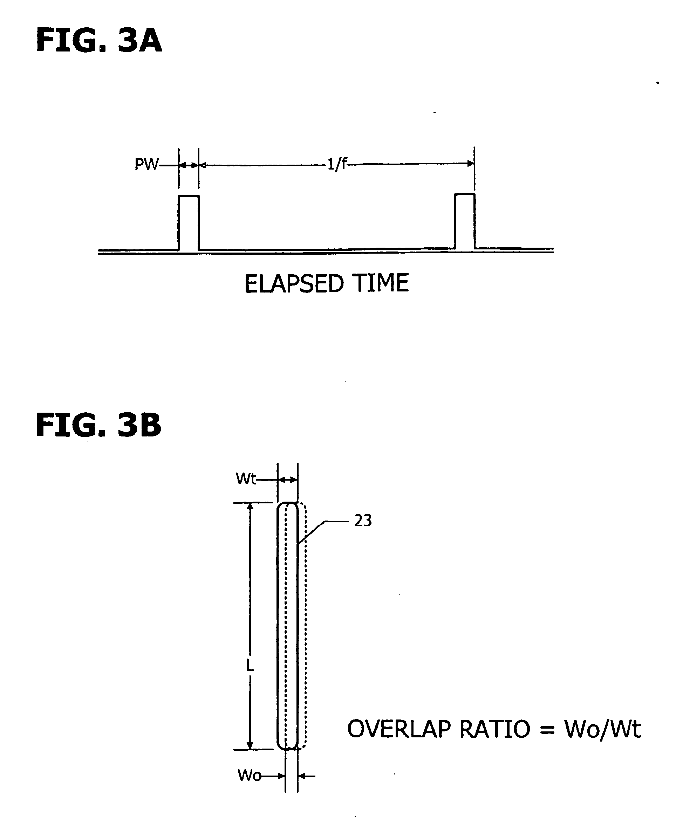

Fig. 3A shows a timing chart of a pulse laser beam that is used in the method of manufacturing the semiconductor device according to the embodiment. The laser pulses having a pulse width PW are radiated to the silicon wafer 30 with a frequency f, that is, a period of 1/f. While the laser pulses are not emitted, a standby current is supplied from the driver 10 to the laser light source 12 so that a laser beam or spontaneous emission light having low intensity of an extent which does not affect the silicon wafer 30 is radiated from the laser light source 12 (Fig. 1). For example, the standby current has a dimension equal to or less than 1% of a driving current when the laser pulse is emitted.

While the laser pulses are not emitted, compared to a case where the laser diode is completely turned off, a life span of the laser diode can be lengthened.

In the silicon wafer 30 at the time of the annealing, an element structure of the front side shown in Fig. 2 is formed in advance, and dopants are ion-implanted in order to form the buffer layer 38 and collector layer 39 on the rear side. At this step, the implanted dopants are not activated.

Fig. 3B shows the beam cross-section 23 on a laser irradiation surface of the silicon wafer 30 (Fig. 1). The beam cross-section 23 has a shape which is long in one direction. Since light intensity distribution related to the longitudinal direction and the width direction is homogenized due to the homogenizer 15 (Fig. 1), the light intensity distribution related to the longitudinal direction and the width direction has a substantially top flat shape.

The length of the longitudinal direction is represented by L, and a beam width is represented by Wt. The irradiation of the pulse laser beam is performed while moving the silicon wafer 30 in the width direction of the beam cross-section 23. The silicon wafer 30 is moved, and thereby, the surface of the silicon wafer 30 is scanned by the pulse laser beam. Since the pulse laser beam scans the surface of the silicon wafer 30 in the beam width direction, annealing of a rectangular region in which the length of one side is the same as the length L of the beam cross-section can be performed.

A width of a range in which the beam cross-section (shown by a solid line in Fig. 3B) of one laser pulse and the beam cross-section (shown by a broken line in Fig. 3B) of the laser pulse which is subsequently incident overlap is represented by Wo. An overlap ratio is defined as Wo/Wt. When a moving speed of the silicon wafer 30 is represented by V, Wt- Wo = V/f is satisfied. Thereby, according to repetition frequency f of the pulse, the beam width Wt, and the moving speed V of the silicon wafer 30, the overlap ratio is determined. In the embodiment, the beam width Wt is set to 240 µm.

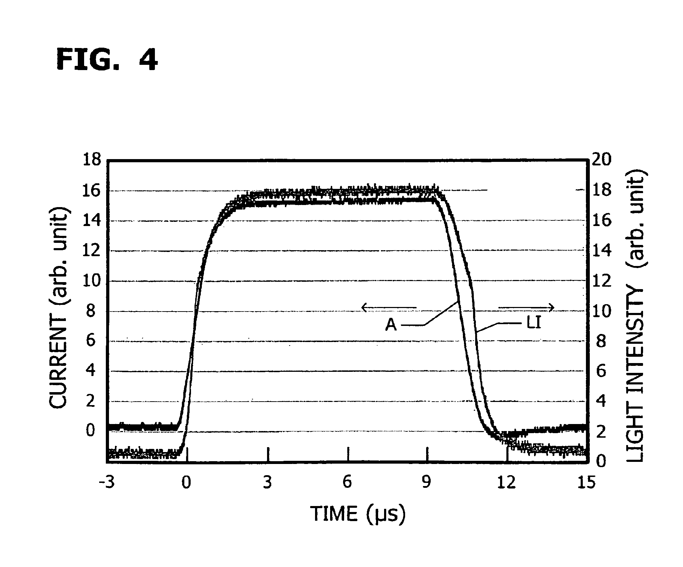

Fig. 4 shows a time waveform A of the pulse current that is supplied to the laser light source 12 and a time waveform LI of the pulse laser that is emitted from the laser light source 12. The horizontal axis represents elapsed time by a unit "µs", the left vertical axis represents magnitude of the current by an arbitrary unit, and the right axis represents the light intensity by an arbitrary unit. The laser beam is terminated by the beam damper, scattered light from the beam damper is detected using a photodiode, and thereby, the light intensity of the laser beam is obtained.

It is understood that the light intensity of the laser beam emitted from the laser light source 12 follows a change of the current. By making the waveform of the pulse current be a top flat, the waveform of the laser pulse emitted from the laser light source 12 can be also made to be a top flat. Here, the "top flat" means that the top portion of the waveform has a shape which can be approximated to a straight line. The straight line approximation is performed under conditions in which an actual measured value of the approximated portion is within a range of ±10% of the mean value.

When a ratio of a time width of the portion approximated to a straight line with respect to the pulse width is decreased, it is difficult to determine whether or not the portion is the top flat. If the time width of the portion in which the current pulse or the laser pulse can approximate to a straight line is longer than the shorter time of rise time and fall time of the time waveform, the portion can be the "top flat". Here, the "rise time" is defined as time which is taken so as to increase from the standby state shown in Fig. 3A up to 90% of the mean intensity of the top flat portion. The "fall time" is defined as time which is taken so as to decrease from the time point in which the intensity is decreased to 90% of the mean intensity of the top flat portion up to the standby state. The "pulse width" means a full width at half maximum of the pulse waveform.

For example, if the time width of the top flat portion is shorter than the rise time and the fall time, it can be considered that the time waveform resembles a triangular wave. As described above, if the time width of the top flat portion is longer than the shorter time of the fall time and the rise time of the time waveform, the time waveform can be distinguished from the triangular wave.

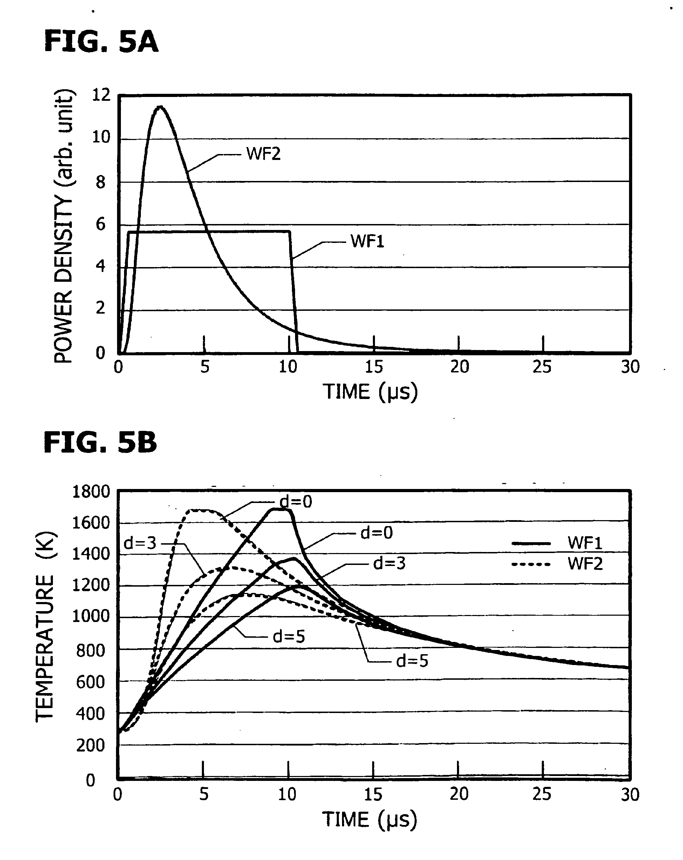

With reference to Figs. 5A and 5B, simulation for indentifying effects when the time waveform of the laser pulse is the top flat will be described.

Fig. 5A shows the time waveform of the laser pulse that is used in the simulation. The horizontal axis represents the elapsed time from the rising point of the pulse by a unit "µs", and the vertical axis represents the power density by an arbitrary unit. Simulation with respect to a time waveform WF1 of the top flat and a time waveform WF2 of the laser pulse that is emitted from a general pulse laser oscillator was performed. The pulse energies and beam sizes in two time waveforms WF1 and WF2 were respectively set to be equal to each other. Since the pulse energy was the same, the area of the time waveform WF1 and area of the time waveform WF2 shown in Fig. 5A were the same as each other The time width of the top flat portion of the time waveform WF1 was 10 µs. The pulse width of the time waveform WF2 was adjusted so that the time at which the surface reaches melting point was the same in temperature history of the time waveforms WF1 and WF2 shown in Fig. 5B described below. In this case, peak power of the time waveform WF1 of the top flat became about 50% of the peak power of the time waveform WF2 of the general laser pulse. The power density of the laser pulse of the time waveform WF1 was 550 kW/cm². The wavelength of the laser beam was set to 800 nm, and the annealing object was a silicon wafer.

Fig. 5B shows the simulation results of a temperature change at positions of depths of 0 µm, 3 µm, and 5 µm after the laser pulse is incident. The horizontal axis represents the elapsed time by a unit "µs", and the vertical axis represents the temperature by a unit "K". A solid line and broken line shown in Fig. 5B represent the temperature changes when the laser pulses of the time waveforms WF1 and WF2 are incident respectively. Numerical values that are added to the solid line and broken line represent the depths from the surface of the silicon wafer by a unit "µm".

The reason why the top portion of the temperature change in 0 µm of the depth becomes substantially flat is because the surface temperature reaches the melting point of the silicon and the laser energy applied to the silicon wafer is consumed as melting heat. If the time waveform of the laser pulse was the top flat, it was understood that the highest arrival temperature at a deep position was increased. As a precondition of the simulation, the pulse energy of the time waveform WF1 of the top flat was the same as the pulse energy of the time waveform WF2 of the general laser pulse. From the simulation results, even when the pulse energy densities were the same as one another, it is understood that it is possible to more effectively increase the temperature of a deep portion by making the time waveform be the top flat. In other words, if the time waveform of the laser pulse is the top flat, it is possible to decrease the pulse energy which is required so as to be heated up to a certain constant temperature.

For example, when activation annealing of the surface of a collector side of an IGBT is performed, it is preferable to suppress the temperature increase of the opposite surface so that structures such as a diffusion region formed on the opposite surface are not damaged. For example, the thickness of the silicon wafer used in the IGBT is about 100 µm. If the laser beam is radiated to the silicon wafer, heat is isotropically diffused from the laser irradiation position. The temperature of the rear surface which is the side opposite to the laser irradiation surface is not almost affected from the time waveform of the laser pulse, and is dependent on the input pulse energy. Since the pulse energy can be decreased by making the time waveform of the laser pulse be the top flat, the temperature increase of the rear surface can be suppressed. Thereby, in suppression of the temperature increase of the rear surface, making the time waveform of the laser pulse be the top flat is effective.

As described above, if the laser diode is used as the laser light source 12 (Fig. 1), it is difficult to increase the power density by narrowing the beam cross-section. Incidentally, if the time waveform of the pulse is the top flat shape, it is possible to heat the region of the deep inner portion from the surface of the silicon wafer up to high temperature without increasing the power density. Moreover, from the standpoint of the life span of the laser diode, it is preferable that the peak power of the laser pulse be set low.

In general, since the output of the laser diode is proportional to an amount of the current that is supplied to the laser diode, the time waveform of the top flat is dependent on the waveform of the pulse current that is supplied from the driver 10 to the laser light source 12. By adjusting the waveform of the pulse current, the pulse width (full width at half maximum) of the laser pulse that has the time waveform of the top flat can be set to a desired value. If the pulse width is too long, significant differences in heating time from the RTA of the related art are lost, and the entire region in the thickness direction of the semiconductor wafer is heated. In order to heat only the vicinity of the surface layer portion of the semiconductor wafer, it is preferable that the pulse width be 100 µs or less. If the pulse width is decreased under conditions in which the pulse energy density is constant, peak power density is increased, and the effects when the time waveform of the top flat is applied can be not obtained. In order to obtain the significant effects when the time waveform of the top flat is applied, it is preferable that the pulse width be 1 µs or more.

The heating time in the laser annealing method according to the embodiment is dependent on the pulse width and is not almost dependent on the shape of the beam cross-section or the scanning speed. Thereby, it is possible to control the heating time with high accuracy.

Boron (B) and phosphorous (P) are implanted to the silicon wafer 30 (Fig. 1), and activation annealing was performed according to various laser irradiation conditions. Here, this estimation experiment will be described.

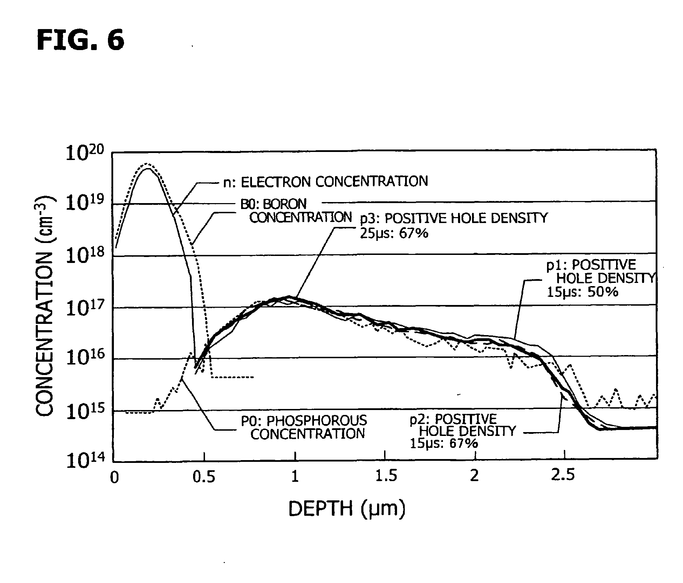

Fig. 6 shows measurement results of dopant concentration distribution and carrier concentration distribution in the depth direction of a sample which is used in the estimation. The horizontal axis represents the depth by a unit "µm" and the vertical axis represents the concentration by a unit "cm⁻³". The implantation of the boron was performed under conditions in which acceleration energy was 40 keV and a dose amount was 1 × 10¹⁵ cm⁻². The implantation of the phosphorous was performed under conditions in which acceleration energy was 700 keV and a dose amount was 1 × 10¹³ cm⁻². A broken line B0 and a broken line P0 represent boron concentration and phosphorous concentration immediately after being implanted respectively. A thin solid line p1 represents positive hole density of a sample S1 in which laser irradiation is performed under conditions in which a pulse width is 15 µs, an overlap ratio is 50%, and frequency is 0.5 kHz, a broken line p2 represents positive hole density of a sample S2 in which laser irradiation is performed in a condition in which a pulse width is 15 µs, an overlap ratio is 67%, and frequency is 0.5 kHz, and a thick solid line p3 represents positive hole density of a sample S3 in which laser irradiation is performed in a condition in which a pulse width is 25 µs, an overlap ratio is 67%, and frequency is 0.5 kHz. Moreover, pulse energy density is the same as the pulse energy density which is applied to the simulation of Fig. 5A. A thin solid line n represents electron concentration of the samples S1, S2, and S3. Since electron concentration distributions of the three samples substantially overlaps with each other, the electron concentration distributions are shown by a single thin solid line.

Since the surface of the silicon substrate is not melted, the electron concentration distribution of the surface layer portion has a shape which reflects the boron concentration distribution immediately after the implantation. In addition, almost 100% of the phosphorous is activated up to 2.5 µm in the depth.

In annealing in which dopants that are ion-implanted to the silicon wafer are activated, it is preferable that the pulse width be 10 µs to 100 µs and the power density be 250 kW/cm² to 750 kW/cm².

In the embodiment, the laser diode having the wavelength of 800 nm is used as the laser light source 12. However, the laser diode having the wavelength of 690 nm to 950 nm may be used.

The rising portion of the laser pulse of the top flat does not almost contribute to the annealing. That is, since the rising portion becomes energy loss, it is preferable that the laser pulse be raised steeply. As an example, it is preferable that the time which is taken when the intensity is raised up to 90% of the mean intensity of the straight portion of the laser pulse waveform is 2 µs or less.

When a thin film having a thermal expansion coefficient different from that of a wafer is formed on the surface of the semiconductor wafer which is the annealing object, peeling of the thin film may occur due to a sharp increase of the temperature. When the peeling of the thin film is concerned, it is preferable to avoid the sharp temperature increase by lengthening the rise time of the pulse.

On the other hand, the fall time of the laser pulse affects cooling speed of a heated semiconductor wafer. The cooling speed may affect annealing effects. If the fall time is lengthened, the cooling speed can be decreased. On the contrary, if the fall time is shortened, the cooling speed can be increased. In order to obtain desired annealing effects, it is preferable to control the fall time of the laser pulse according to the purpose of the annealing. The fall time of the laser pulse can be adjusted by the time waveform of the pulse current that is supplied to the laser light source 12 (Fig. 1).

In general, the top flat means that a physical amount (light intensity at a case of the laser pulse and magnitude of the current at a case of a current pulse) of a region between the rising portion and the falling portion of the pulse is substantially constant. The light intensity of the laser pulse in the top flat region may be increased or decreased at a fixed ratio according to the material or the configuration of an annealing object. In the above-described embodiment, the preferable time waveform of the laser pulse which has the object of effectively heating the deep region of the silicon wafer is described. The rise time and fall time of the laser pulse, the increase and decrease of the intensity of the top flat portion, or the like may be optimized according to the material or the configuration of an annealing object.

In order to make the laser pulse that is emitted from the laser light source 12 be the top flat, it is preferable that electric power required to emit one pulse be reserved in the capacitor 10A in advance. Thereby, the electric power required to emit one pulse can be stably supplied to the laser light source 12.

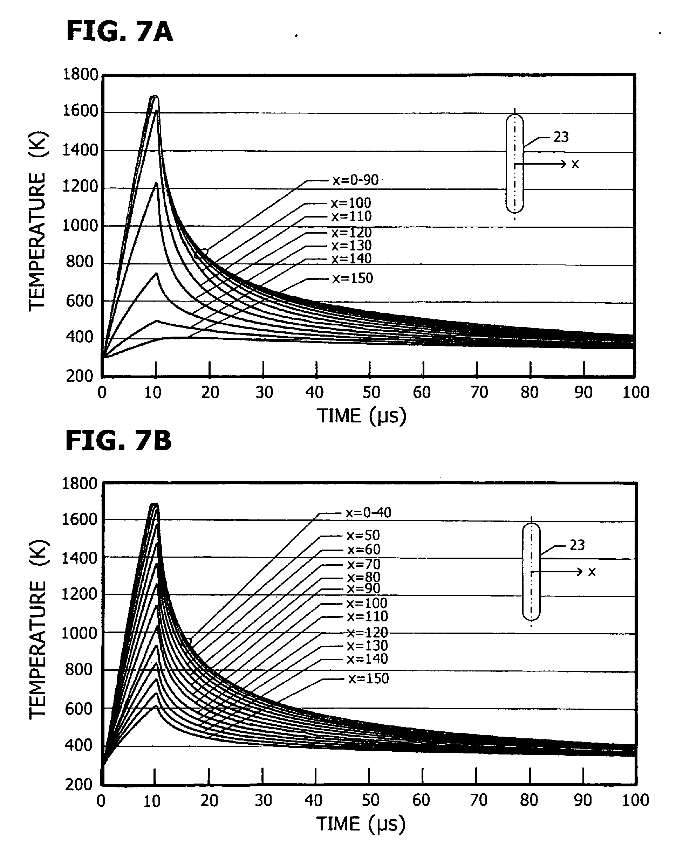

Next, with reference to Figs. 7A and 7B, a space profile of the laser beam will be described.

Fig. 7A shows simulation results of a time-dependent change in temperature of the silicon wafer surface when laser annealing is performed using the laser annealing device according to the embodiment. Fig. 7B shows simulation results of a time-dependent change in temperature of the silicon wafer surface when laser annealing is performed using a laser beam that has a beam profile of Gaussian distribution related to the width direction in the beam cross-section. The horizontal axis represents elapsed time from the time point when the laser beam is radiated by a unit "µs", and the vertical axis represents temperature by a unit "K". Numerical values that are added to each curve represent distances x from the center related to the width direction of the beam cross-section 23 of Fig. 3B by a unit "µm".

In the case of the embodiment in which the space profile of the laser beam is the top flat, as shown in Fig. 7A, it is understood that the temperatures of the regions in which the distances from the center in the width direction of the beam cross-section are 100 µm or less are substantially the same. In contrast, when the annealing is performed by the laser beam having the beam profile of Gaussian distribution, as shown in Fig. 7B, the regions in which the temperatures are substantially the same, are narrower compared to the case shown in Fig. 7A. Thereby, deviation of activation rate related to the width direction of the beam cross-section occurs. In order to make the activation rate related to the inner portion of the surface of the silicon wafer uniform, it is preferable to make the space profile be the top flat.

The present invention is described according to the embodiment. However, the present invention is not limited to this. For example, it is obvious to those skilled in the art that various modifications, refinements, combinations, or the like may be performed.

## Claims

1. A laser annealing device comprising:
a laser diode (12) that emits a laser pulse when a pulse current is input;
an optical system (13, 19, 20) that guides a laser beam emitted from the laser diode up to an annealing object; and **characterized by** that
a driver (10) that supplies a pulse current that has a time waveform of a top flat and a pulse width of 1 µs to 100 µs to the laser diode (12)

2. The laser annealing device according to claim 1,
wherein the driver (10) includes a capacitor (10A) that accumulates electric power supplied from a power source (11), and a pulse waveform shaping circuit (106) that extracts the pulse current from the capacitor (10A).

3. The laser annealing device according to claim 2,
wherein the driver (10) accumulates electric power that is larger than electric power required for one output of the laser pulse in the capacitor before the pulse current is supplied to the laser diode.

4. The laser annealing device according to any one of claims 1 to 3,
wherein the driver (10) periodically supplies the pulse current to the laser diode (12) and the driver supplies a current having a magnitude equal to or less than 1% of a maximum current value of the pulse current to the laser diode (12) while the pulse current is not supplied.

5. The laser annealing device according to any one of claims 1 to 4,
wherein, in use, a time width of a top flat portion in a time waveform of the pulse current is longer than the shorter time of rise time and fall time.

6. The laser annealing device according to any one of claims 1 to 5,
wherein the optical system (13, 15, 16, 19, 20) makes a beam cross-section on a surface of the annealing object be a long shape, and includes a homogenizer (15) which makes light intensity distribution related to a longitudinal direction and width direction of the beam cross-section be a top flat shape.

7. A laser annealing method comprising:
a step of ion-implanting a dopant on a second surface opposite to a first surface of a silicon wafer (30) in which an element structure including a dopant diffusion region is formed on the first surface, and **characterised by**
a step of, after implanting the dopant, emitting a pulse laser beam that has a wavelength of 690 nm to 950 nm, a pulse width of 10 µs to 100 µs, and a time waveform of a top flat on the second surface of the silicon wafer (30) to activate the dopant under conditions in which a power density on the surface of the silicon wafer is 250 kW/cm² to 750 kW/cm².

## Patentansprüche

1. Laserwärmebehandlungsvorrichtung, die Folgendes aufweist:
eine Laser-Diode (12), die einen Laserimpuls aussendet, wenn ein Stromimpuls eingegeben wird;
ein optisches System (13, 19, 20), welches einen Laserstrahl, der von der Laserdiode ausgesendet wird, zu einem wärmezubehandelnden Objekt leitet; **gekennzeichnet durch**
einen Treiber (10), der einen Stromimpuls an die Laser-Diode (12) liefert, der eine Zeitwellenform mit flacher Oberseite und einer Pulsbreite von 1 µs bis 100 µs hat.

2. Laserwärmebehandlungsvorrichtung nach Anspruch 1, wobei der Treiber (10) einen Kondensator (10A) aufweist, der elektrische Leistung sammelt, die von einer Leistungsquelle (11) geliefert wird, und eine Pulswellenform-Formgebungsschaltung (10B), die den Stromimpuls aus dem Kondensator (10A) zieht.

3. Laserwärmebehandlungsvorrichtung nach Anspruch 2, wobei der Treiber (10) elektrische Leistung im Kondensator sammelt, die größer ist als die elektrische Leistung, die für eine Ausgabe des Laserimpulses erforderlich ist, und zwar bevor der Stromimpuls zur Laserdiode (12) geliefert wird.

4. Laserwärmebehandlungsvorrichtung nach einem der Ansprüche 1 bis 3, wobei der Treiber (10) periodisch den Stromimpuls an die Laser-Diode (12) liefert, und wobei der Treiber einen Strom an die Laser-Diode (12) liefert, der eine Größe von gleich oder weniger als 1 % des maximalen Stromwertes des Stromimpulses hat, und zwar während der Stromimpuls nicht geliefert wird.

5. Laserwärmebehandlungsvorrichtung nach einem der Ansprüche 1 bis 4, wobei bei der Anwendung eine zeitliche Breite des flachen oberen Teils in einer Zeitwellenform des Stromimpulses länger ist als die kürzere Zeit von Anstiegszeit und Abfallzeit.

6. Laserwärmebehandlungsvorrichtung nach einem der Ansprüche 1 bis 5, wobei das optische System (13, 15, 16, 19, 20) einen Strahlquerschnitt auf einer Oberfläche des wärmezubehandelnden Objektes erzeugt, der eine langgestreckte Form hat, und wobei es eine Homogenisierungsvorrichtung (15) aufweist, welche die Lichtintensitätsverteilung bezüglich einer Längenrichtung und einer Breitenrichtung des Strahlquerschnitts zu einer flachen oberen Form macht.

7. Laserwärmebehandlungsverfahren, welches Folgendes aufweist:
einen Schritt des Ionenimplantierens eines Dotierungsmittels auf einer zweiten Oberfläche gegenüberliegend zu einer ersten Oberfläche eines Silizium-Wafers (30), in welchem eine Elementenstruktur, die eine Dotierungsmitteldiffusionsregion aufweist, auf der ersten Oberfläche geformt ist, **gekennzeichnet durch**
einen Schritt des Emittierens eines Laserimpulsstrahls nach dem Implantieren des Dotierungsmittels, welcher eine Wellenlänge von 690 nm bis 950 nm, eine Pulsbreite von 10 µs bis 100 µs und eine Zeitwellenform mit einem flachen oberen Teil hat, und zwar auf die zweite Oberfläche des Silizium-Wafers (30), um das Dotierungsmittel unter Bedingungen zu aktivieren, bei denen eine Leistungsdichte auf der Oberfläche des Silizium-Wafers 250 kW/cm² bis 750 kW/cm² ist.

## Revendications

1. Dispositif de recuit au laser, comprenant :
une diode laser (12) qui émet une impulsion laser lorsqu'un courant en impulsion est appliqué ;
un système optique (13, 19, 20) qui guide un faisceau laser émis par la diode laser jusqu'à un objet à recuire ; et **caractérisé par**
un dispositif de commande (10) qui fournit à la diode laser (12) un courant en impulsion qui a une forme d'onde temporelle ayant un sommet plat et une largeur d'impulsion de 1 µs à 100 µs.

2. Dispositif de recuit au laser selon la revendication 1,
dans lequel le dispositif de commande (10) comprend un condensateur (10A) qui accumule de l'énergie électrique fournie par une source d'alimentation (11), et un circuit de mise en forme d'onde d'impulsion (10B) qui extrait le courant en impulsion du condensateur (10A).

3. Dispositif de recuit au laser selon la revendication 2,
dans lequel le dispositif de commande (10) accumule dans le condensateur de l'énergie électrique en quantité supérieure à l'énergie électrique requise pour une seule sortie de l'impulsion laser, avant que le courant en impulsion soit fourni à la diode laser (12).

4. Dispositif de recuit au laser selon l'une quelconque des revendications 1 à 3,
dans lequel le dispositif de commande (10) fournit périodiquement le courant en impulsion à la diode laser (12) et le dispositif de commande fournit à la diode laser (12) un courant ayant une amplitude égale ou inférieure à 1 % de la valeur de courant maximum du courant en impulsion, pendant que le courant en impulsion n'est pas fourni.

5. Dispositif de recuit au laser selon l'une quelconque des revendications 1 à 4,
dans lequel, en utilisation, la largeur d'une portion plate supérieure dans une forme d'onde temporelle du courant en impulsion est plus grande que le temps le plus court entre le temps de montée et le temps de descente.

6. Dispositif de recuit au laser selon l'une quelconque des revendications 1 à 5,
dans lequel le système optique (13, 15, 16, 19, 20) réalise une section de faisceau de forme allongée sur une surface de l'objet à recuire, et comprend un dispositif d'homogénéisation (15) qui donne à la distribution d'intensité lumineuse, associée à une direction longitudinale et une direction de largeur de la section du faisceau, une forme à sommet plat.

7. Procédé de recuit au laser comprenant :
une étape d'implantation ionique d'un dopant sur une deuxième surface opposée à une première surface d'une plaquette de silicium (30), dans laquelle une structure d'élément comprenant une région de diffusion de dopant est formée sur la première surface, et **caractérisé par**
une étape, après l'implantation de dopant, d'émission d'un faisceau laser pulsé qui a une longueur d'onde de 690 nm à 950 nm, une largeur d'impulsion de 10 µs à 100 µs, et une forme d'onde temporelle à sommet plat, sur la deuxième surface de la plaquette de silicium (30) pour activer le dopant dans des conditions où la densité de puissance sur la surface de la plaquette de silicium est de 250 kW/cm² à 750 kW/cm².
